# EUROPÄISCHE PATENTSCHRIFT

(11) **EP 1 647 094 B1**
(45) Veröffentlichungstag und Bekanntmachung des Hinweises auf die Patenterteilung: **04.09.2013**
(21) Anmeldenummer: 04741017.0
(22) Anmeldetag: 15.07.2004
(51) Int. Cl.: H03K 17/95, F16P 3/08

(54) **VERFAHREN UND VORRICHTUNG ZUM SICHEREN ÜBERWACHEN EINER SCHL IESSPOSITION ZWEIER RELATIV ZUEINANDER BEWEGLICHER TEILE**
METHOD AND DEVICE FOR RELIABLY CONTROLLING THE CLOSING POSITION OF TWO PARTS THAT CAN MOVE RELATIVE TO ONE ANOTHER
PROCEDE ET DISPOSITIF DE CONTROLE SUR D'UNE POSITION DE FERMETURE DE DEUX PIECES POUVANT SE DEPLACER RELATIVEMENT L'UNE PAR RAPPORT A L'AUTRE

(30) Priorität: 21.07.2003 DE 10334653
(43) Veröffentlichungstag der Anmeldung: 19.04.2006
(73) Patentinhaber: Pilz GmbH & Co. KG, 73760 Ostfildern (DE)
(72) Erfinder: PULLMANN, Juergen, 73061 Ebersbach (DE); ZINSER, Christoph, 72649 Wolfschlugen (DE); NITSCHE, Thomas, 73732 Esslingen (DE)
(74) Vertreter: Duhme, Torsten
(86) Internationale Anmeldenummer: PCT/EP2004/007814
(87) Internationale Veröffentlichungsnummer: WO 2005/013488

(56) Entgegenhaltungen:
- DE-A- 3 007 929
- DE-A- 3 440 027
- DE-A- 4 041 550
- DE-A- 4 233 922
- DE-A- 4 438 039
- DE-C- 10 000 799

## Beschreibung

Die vorliegende Erfindung betrifft eine Vorrichtung zum sicheren Überwachen einer Schließposition zweier relativ zueinander beweglicher Teile, insbesondere zur Verwendung als Türkontaktschalter bei einer Schutztür zum Absichern einer automatisiert arbeitenden technischen Anlage, mit einem Betätiger und mit einem Sensor, die an jeweils einem der Teile fixierbar sind, wobei der Sensor einen eingangsseitigen Empfangskreis aufweist, der bei Unterschreiten einer Schaltentfernung zwischen Sensor und Betätiger ein definiertes Empfangskreissignal erzeugt, mit einem Detektorkreis, der bei Vorliegen des definierten Empfangskreissignals ein Freigabesignal bereitstellt, und mit einem Testelement.

Die Erfindung betrifft ferner ein Verfahren zum sicheren Überwachen einer Schließposition zweier relativ zueinander beweglicher Teile, insbesondere zum Absichern einer automatisiert arbeitenden technischen Anlage mit Hilfe einer Schutztür, mit den Schritten:
- Anordnen eines Betätigers an einem der beweglichen Teile,
- Anordnen eines Sensors mit einem eingangsseitigen Empfangskreis an dem anderen der beweglichen Teile,
- Erzeugen eines definierten Empfangskreissignals mit Hilfe des Empfangskreises, wenn eine Schaltentfernung zwischen Sensor und Betätiger unterschritten wird,
- Erzeugen eines Freigabesignals mit Hilfe eines Detektorkreises, wenn das definierte Empfangskreissignal vorliegt,
   und
- Testen des Sensors mit Hilfe eines Testelements.

Eine gattungsgemäße Vorrichtung und ein entsprechendes Verfahren sind beispielsweise aus DE 100 00 799 C1 bekannt.

Gattungsgemäße Vorrichtungen werden vor allem im Bereich der Maschinen- und Anlagensicherheit eingesetzt, wenn es darum geht, Gefahren, die von einer automatisiert arbeitenden Anlage ausgehen, zu vermeiden. Neben anderen Schutzmaßnahmen, wie beispielsweise Lichtschranken, Trittmatten, Zwei-Hand-Schaltern etc. werden zum Schutz von Bedienpersonen in solchen Anlagen häufig Schutztüren, -klappen o.ä. eingesetzt. Die Türen sind mit einer Betätiger-Sensor-Kombination versehen, die ein Öffnen der Schutztür zuverlässig, d.h. (ein-)fehlersicher, erkennen müssen, so dass die Maschine oder Anlage ggf. in einen gefahrlosen Zustand versetzt werden kann. Entsprechende BetätigerSensor-Kombinationen fallen damit in den Bereich derjenigen Bauteile, die für ihre Verwendung eine entsprechende Zulassung von Seiten zuständiger Aufsichtsbehörden benötigen. Die vorliegende Erfindung bezieht sich daher insbesondere auf Vorrichtungen und Verfahren der eingangs genannten Art, die zumindest die Kategorie 3, bevorzugt sogar die höchste Kategorie 4 der einschlägigen europäischen Norm EN 954-1 oder vergleichbare Sicherheltsanforderungen für eine Verwendung zur Absicherung von technischen Anlagen erfüllen.

Einschlägige Betätiger-Sensor-Kombinationen sind im Stand der Technik vielfach bekannt. Besondere Aufmerksamkeit haben berührungslos zusammenwirkende Betätiger-Sensor-Kombinationen gewonnen. Derartige Vorrichtungen basieren in aller Regel auf magnetischen und/oder elektromagnetischen Kopplungen zwischen Betätiger und Sensor, die beim Öffnen der Schutztür unterbrochen oder gestört werden. Magnetische Sensoren können allerdings in manchen Bereichen, beispielsweise bei der spanabhebenden Bearbeitung von metallischen Werkstücken, nicht oder nur beschränkt eingesetzt werden.

Um die erforderliche Fehlersicherheit zu erreichen, sind die gattungsgemäßen Vorrichtungen in aller Regel zweikanaligredundant aufgebaut. Beispielhaft hierzu sei auf die Druckschriften DE 40 41 550 A1 oder DE 44 38 039 A1 verwiesen.

Aus EP 0 968 567 B1 ist eine gattungsgemäße Vorrichtung bekannt, bei der der Betätiger ein Transponder ist, der eine intern abgespeicherte Codierung berührungslos an einen Sensor (dort als Lesekopf bezeichnet) übertragen kann, sofern die Entfernung zwischen Betätiger und Sensor eine bestimmte Schaltentfernung unterschreitet. Dem sensorseitigen Empfangskreis, der zum Auslesen des Transponders verwendet wird, ist eine zweikanalig-redundante Auswerteeinrichtung nachgeschaltet, die das vom Empfangskreis gelieferte Sensorsignal auswertet und in Abhängigkeit davon zwei ausgangsseitige Relais öffnet, mit denen dann beispielsweise eine überwachte Maschine abgeschaltet wird.

Diese bekannte Vorrichtung besitzt den Nachteil, dass bei der Überwachung mehrerer Schutztüren eine entsprechende Anzahl von Auswerteeinrichtungen erforderlich ist. Alternativ hierzu ist es zwar grundsätzlich denkbar, mehrere Betätiger mit einer gemeinsamen Auswerteeinrichtung auszuwerten; in diesem Fall erhöht sich jedoch entweder die Reaktionszeit der Vorrichtung und/oder deren Komplexität.

DE 100 00 799 C1 beschreibt eine einkanalig ausgelegte Vorrichtung zum Schalten einer elektrischen Verbindung in Abhängigkeit des Zustandes einer zu überwachenden Einrichtung. Die Vorrichtung weist dabei einen Testeingang auf, der mit einer Versorgungsspannung verbunden ist und das Ausgangssignal, welches einem Freigabesignal entspricht, unabhängig vom tatsächlichen Zustand der zu überwachenden Einrichtung temporär in den vermeintlich "gefährlichen" Zustand überführen kann. So kann, ohne die überwachende Einrichtung tatsächlich in den "gefährlichen" Zustand zu überführen, die Funktionsweise des Schalters überprüft werden. Nachteilig bei dieser Testvorrichtung ist, dass das Testelement das Ausgangssignal direkt manipuliert und somit nicht unmittelbar die fehlerhafte Funktion, nämlich das Austreten des Betätigers aus dem Bereich des Sensors, simuliert.

Vor diesem Hintergrund ist es eine Aufgabe der vorliegenden Erfindung, ein alternatives Konzept für ein Verfahren und eine Vorrichtung der eingangs genannten Art anzugeben, das es ermöglicht, eine Mehrzahl von Schutztüren schnell, sicher (im Sinne von fehlersicher) und effizient auf eine Schließposition hin zu überwachen.

Diese Aufgabe wird bei einer Vorrichtung der eingangs genannten Art dadurch gelöst, dass das Testelement dazu ausgebildet ist, das definierte Empfangskreissignal gezielt zu unterdrücken, wobei der Empfangskreis eine Induktivität und eine damit verbundene Kapazität beinhaltet und das Testelement dazu ausgebildet ist, die Induktivität und die Kapazität elektrisch voneinander zu trennen, oder wobei das Testelement dazu ausgebildet ist, den Empfangskreis vom Detektorkreis zu trennen.

Die Aufgabe wird ferner mit einem Verfahren der eingangs genannten Art gelöst, bei dem bei Vorliegen des definierten Empfangskreissignals dieses mit Hilfe des Testelements kurzzeitig unterdrückt wird, wobei der Empfangskreis eine Induktivität und eine damit verbundene Kapazität beinhaltet und das Testelement dazu ausgebildet ist, die Induktivität und die Kapazität elektrisch voneinander zu trennen, oder wobei das Testelement dazu ausgebildet ist, den Empfangskreis vom Detektorkreis zu trennen, und bei dem eine Überwachungsmeldung erzeugt wird, wenn der Detektorkreis auf die Unterdrückung des definierten Empfangskreissignals nicht reagiert.

Das genannte Testelement ist bevorzugt ein Transistor, ein Relais, eine PIN-Diode oder ein anderes elektrisches, elektronisches oder auch optisches Schaltelement, mit dessen Hilfe es möglich ist, von einem normalerweise stattfindenden Überwachungsbetrieb auf einen kurzzeitigen Testbetrieb umzuschalten. Elektrische/elektronische oder optische Schaltelement sind dabei bevorzugt, da sie es ermöglichen, in den Testbetrieb überzugehen, ohne dass mechanische Aktionen, wie insbesondere das kurzzeitige Öffnen oder Freigeben der Schutztür, erforderlich sind. Grundsätzlich kann das Testelement jedoch auch mechanisch sein. Mit anderen Worten kommt es in der allgemeinsten Form der Erfindung nur darauf an, dass mit Hilfe des Testelements ein automatischer Test der Sensor-Betätiger-Kombination von außen möglich ist.

Mit Hilfe des neuen Testelements ist es möglich, das definierte Empfangskreissignal, das bei ordnungsgemäßem Betrieb der Vorrichtung eine geschlossene (Schutz-)Tür signalisiert, von außen auf seine Gültigkeit hin zu überprüfen. Dies wiederum macht es möglich, den zur Auswertung des Empfangskreissignals verwendeten Detektorkreis relativ einfach auszubilden. Im Gegensatz zu gattungsgemäßen Vorrichtungen ist es damit nicht mehr zwingend erforderlich, dass das Freigabesignal des Detektorkreises für sich genommen ein fehlersicheres Schaltsignal ist. Anders ausgedrückt kann auf Grund des neuen Konzeptes zugelassen werden, dass der Detektorkreis ein Freigabesignal liefert, das für sich genommen keine fehlersichere Aussage über die Schließposition der (Schutz-)Tür zulässt. Mit Hilfe des neuen Testelements kann die Plausibilität des Freigabesignals aus dem Detektorkreis jedoch von außen überprüft werden, so dass insgesamt weiterhin die gewünschte fehlersichere Aussage über die Schließposition der (Schutz-)Tür möglich ist.

Auf Grund des neuen Konzeptes ist es möglich, den Detektorkreis zur Auswertung des Empfangskreissignals sehr kostengünstig und zudem auch sehr kleinbauend zu realisieren. Dies wiederum erlaubt es, den Detektorkreis kostengünstig in dem Sensor an jeder (Schutz-) Tür zu integrieren. Eine Mehrzahl von Schutztüren kann daher mit kostengünstigen Betätiger-Sensor-Kombinationen abgesichert werden. Die endgültige Entscheidung über das Abschalten der überwachten Anlage kann dorthin verlagert werden, wo ein dem neuen Schaltelement zuzuführendes Testsignal generiert und überwacht wird, vorzugsweise also in ein abgesetztes fehlersicheres Schaltgerät oder eine zentrale Sicherheitssteuerung, die auch in bisherigen Konstellationen üblicherweise vorhanden war.

Beinhaltet der Empfangskreis eine Induktivität und eine damit verbundene Kapazität, so ist das Schaltelement dazu ausgebildet, die Induktivität und die Kapazität elektrisch voneinander zu trennen.

Eine derartige Anordnung des Schaltelements hat sich als besonders wirkungsvoll erwiesen, da der Empfangskreis durch das Auftrennen von Induktivität und Kapazität "unbrauchbar" gemacht wird. Das Empfangskreissignal wird hierdurch auf sehr einfache Weise und mit besonders hoher Realitätstreue im Vergleich zu dem Öffnen der Schutztür unterdrückt.

Alternativ könnte das Schaltelement auch den Empfangskreis vom Detektorkreis trennen.

Das Empfangskreissignal wird dabei nicht unbedingt im engeren Sinne unterdrückt, wenngleich dies bei bekannten IC's zur Auswertung von Transpondern trotzdem in aller Regel eine Konsequenz ist. Entscheidend für die praktische Umsetzung des neuen Konzepts ist jedoch nicht vorrangig, dass das Empfangskreissignal "verschwindet", sondern dass es den nachgeschalteten Detektorkreis nicht mehr erreicht, so dass dieser von einem Öffnen der (Schutz-)Tür ausgehen muss. Dies kann im Rahmen der vorliegenden Erfindung auch dadurch erreicht werden, dass der Empfangskreis für sich genommen intakt bleibt, jedoch vom Detektorkreis abgetrennt wird. Der Begriff "Unterdrücken" bedeutet in diesem Zusammenhang folglich, dass das Empfangskreissignal aus Sicht des Detektorkreises "verschwindet". Vorteil dieser Ausgestaltung ist insbesondere, dass die Induktivität und die Kapazität eines Schwingkreises weiterhin unmittelbar miteinander kombiniert werden können. Dies erleichtert die exakte Abstimmung des Schwingkreises und damit dessen Frequenzgenauigkeit und -stabilität.

Da das abgesetzte Sicherheitsschaltgerät bzw. die zentrale Sicherheitssteuerung nicht mit der Aufgabe betraut ist, die originären Empfangskreissignale der einzelnen Betätiger-Sensor-Kombinationen auszuwerten, wird die Reaktionszeit der Gesamtvorrichtung auch bei der Überwachung mehrerer Betätiger-Sensor-Kombinationen nicht erhöht.

Insgesamt bietet das neue Konzept damit die Möglichkeit, eine Vielzahl von Schutztüren mit vergleichsweise einfachen und kostengünstigen Betätiger-Sensor-Kombinationen abzusichern, ohne dass sich dies nachteilig auf die Komplexität der Anordnung und/oder die Reaktionszeit der Gesamtvorrichtung auswirkt.

Die oben genannte Aufgabe ist damit vollständig gelöst.

Bei Verwendung eines nicht-mechanischen Testelements besitzt das neue Konzept darüber hinaus den Vorteil, dass das Unterdrücken des Empfangskreissignals die "kritische" Situation, dass nämlich der Betätiger aus dem Bereich des Sensors entfernt wird, außerordentlich realistisch simuliert, ohne dass jedoch die (Schutz-)Tür tatsächlich geöffnet werden muss, was einen Sicherheitsverlust zur Folge hätte. Durch diese realistische Simulation lässt sich der gesamte Sicherheitskreis in einem Testzyklus auf einwandfreie Funktion hin überprüfen, was eine sehr zuverlässige Absicherung einer Gefahr bringenden Anlage ermöglicht.

Die Aufgabe der Erfindung ist durch die Merkmale des Anspruchs 1 gelöst.

In einer bevorzugten Ausgestaltung der Erfindung ist das Test-element im Bereich des Empfangskreises angeordnet.

Diese Ausgestaltung besitzt den Vorteil, dass sich das Empfangskreissignal "am Ort seiner Entstehung" unterdrücken lässt, was die zum Überprüfen der Gesamtvorrichtung verwendete Simulation noch realistischer macht. Darüber hinaus ist die Überwachung hierdurch weitgehend entkoppelt von der Länge von Zuführungsleitungen zum Schaltelement und damit unabhängig von anlagenspezifischen Gegebenheiten. Schließlich kann das Testelement in dieser Ausgestaltung sehr einfach in den Sensor integriert werden, was eine herstellerseitige Funktions- und Qualitätskontrolle und auch die Installation der Vorrichtung vor Ort erleichtert.

In einer weiteren Ausgestaltung beinhaltet der Betätiger ein Transponderelement mit einer darin abgelegten Information und der Sensor ist dazu ausgebildet, die Information bei Unterschreiten der definierten Entfernung mit Hilfe des Empfangskreises auszulesen. Vorzugsweise ist der Betätiger ein Transponder.

Geeignete Transponder sind mittlerweile als Standardprodukte für zahlreiche Anwendungen, wie beispielsweise für Wegfahrsperren in Kraftfahrzeugen, erhältlich. Ebenso gibt es weitgehend einsatzfertige IC's, die dazu ausgebildet sind, die in den Transpondern abgelegte Information auszulesen und als Datenwert bereitzustellen. In aller Regel handelt es sich um eine eindeutige Information in Form einer Identifikationsnummer, die der Transponder auf eine elektromagnetische Anregung hin in Form eines amplitudenmodulierten Antwortsignals abgibt. Dieses Antwortsignal lässt sich mit Hilfe des eingangsseitigen Empfangskreises aufnehmen, wobei das definierte Empfangskreissignal dann die transponderseitige Information erhält. Die vorliegende Ausgestaltung besitzt den Vorteil, dass aufgrund der (vorzugsweise individuellen) Information eine Redundanz vorliegt, die im Sinne einer Fehlersicherheit vorteilhaft ausgewertet werden kann. Insbesondere lässt sich durch Auswertung der im Transponder abgelegten Information verhindern, dass ein "beliebiger" Betätiger anstelle des herstellerseitig vorgesehenen Betätigers eingesetzt wird. Gewollte oder ungewollte Manipulationen, die die Sicherheit gefährden, sind auf diese Weise wesentlich erschwert, wenn nicht gar unmöglich.

In einer weiteren Ausgestaltung ist der Sensor dazu ausgebildet, die Information bei Unterschreiten der definierten Entfernung stetig wiederholt auszulesen.

Durch diese Ausgestaltung wird auf einfache Weise eine Dynamik erzeugt, mit der sich die Fehlersicherheit der Vorrichtung noch einfacher und weiter verbessern lässt.

In einer weiteren Ausgestaltung beinhaltet der Detektorkreis einen Logikbaustein, der das Freigabesignal nur dann bereitstellt, wenn die Information aus dem Betätiger mit einer vorgegebenen Information übereinstimmt.

Diese Ausgestaltung knüpft an den bereits weiter oben erwähnten Gedanken an, die Information des Transponders zur Vermeidung von Manipulationen und zur Erhöhung der Fehlersicherheit auszuwerten. Die Fehlersicherheit und Manipulierbarkeit der Vorrichtung lässt sich damit noch weiter verbessern.

In einer weiteren Ausgestaltung weist der Detektorkreis einen Betriebsmodus auf, in dem der Logikbaustein die vorgegebene Information einliest, und zwar vorzugsweise vom Betätiger.

In dieser Ausgestaltung ist der Detektorkreis somit "lernfähig", d.h. er kann auf die individuelle Information eines einzelnen Transponders eingelernt werden. Alternativ hierzu wäre es grundsätzlich auch möglich, innerhalb einer Produktionsserie Transponder mit einheitlicher Information zu verwenden. Durch die bevorzugte Ausgestaltung werden Manipulationen noch weiter erschwert und die Fehlersicherheit dementsprechend noch weiter verbessert.

In einer weiteren Ausgestaltung ist ferner eine - vorzugsweise räumlich vom Sensor abgesetzte - Auswerte- und Steuereinheit vorhanden, die dazu ausgebildet ist, das erste Empfangskreissignal mit Hilfe des Schaltelements zyklisch zu unterdrücken.

Diese Ausgestaltung macht von den durch das neue Konzept gegebenen Möglichkeiten besonders vorteilhaften Gebrauch, da eine zyklische Unterdrückung des Empfangskreissignals eine zyklische Überprüfung des Freigabesignals auf Plausibilität ermöglicht. Die Verwendung einer räumlich vom Sensor abgesetzten Auswerte- und Steuereinheit, beispielsweise in Form eines Sicherheitsschaltgerätes oder einer Sicherheitssteuerung, ermöglicht dabei eine kostengünstige und effiziente Überwachung von mehreren Schutztüren von einer zentralen Einheit aus. Des Weiteren ermöglicht diese Ausgestaltung, den Detektorkreis und damit die Sensoren in besonders kleinbauender und kostengünstiger Weise auszubilden.

In einer weiteren bevorzugten Ausgestaltung ist der Detektorkreis im Sensor integriert, insbesondere also zusammen mit dem Empfangskreis in einem Sensorgehäuse angeordnet.

Diese Ausgestaltung vereinfacht die Installation der Gesamtvorrichtung und ermöglicht zudem eine zuverlässige herstellerseitige Qualitäts- und Fehlerkontrolle. Darüber hinaus findet in dieser Ausgestaltung der Testbetrieb "ganz vorne" statt, d.h. durch das Unterdrücken des Empfangskreissignals wird die Gesamtvorrichtung sehr realitätstreu überprüft.

Bevorzugt ist der Detektorkreis einkanalig ausgebildet. Insbesondere besitzt er nur ein sogenanntes Tag-Reader IC, d.h. nur einen Schaltkreis zum Auswerten eines Transpondercodes, und/oder nur einen (relativ einfachen) Mikroprozessor.

Diese Ausgestaltung macht von den Möglichkeiten des neuen Konzepts besonders vorteilhaften Gebrauch, da der Detektorkreis hiernach sehr einfach, kleinbauend und damit auch sehr kostengünstig realisierbar ist. Zudem vereinfacht sich die bei Sicherheitsanwendungen vorgeschriebenen Fehlerbetrachtung, was die Entwicklungskosten weiter reduziert.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine schematische Darstellung einer erfindungsgemäßen Vorrichtung zum Absichern einer automatisiert arbeitenden Anlage, und
- Fig. 2: ein vereinfachtes elektrisches Schaltbild für ein bevorzugtes Ausführungsbeispiel der Betätiger-Sensor-Kombination der neuen Vorrichtung.

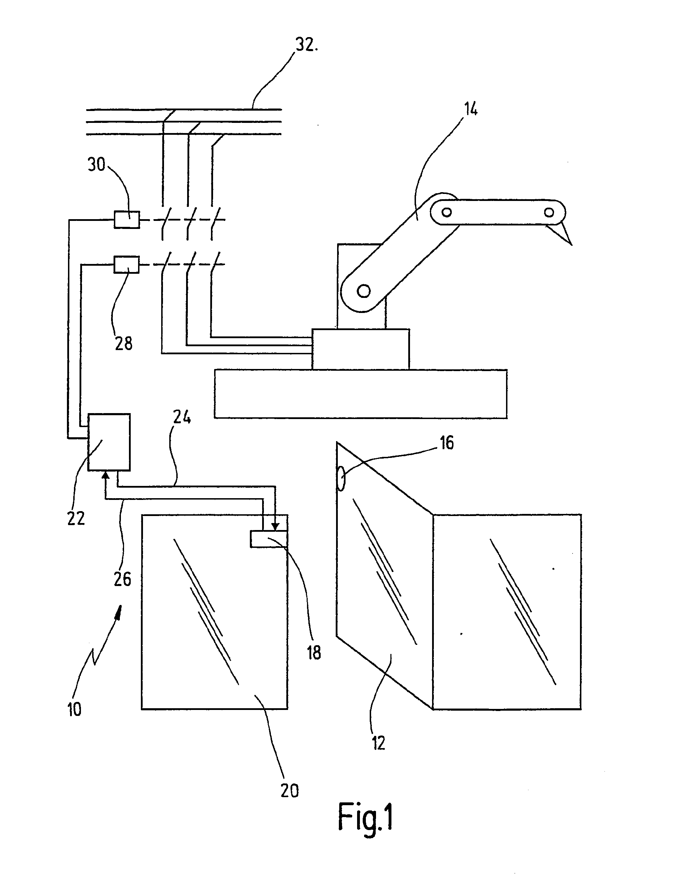

In Fig. 1 ist ein Ausführungsbeispiel der neuen Vorrichtung in seiner Gesamtheit mit der Bezugsziffer 10 bezeichnet.

Die Vorrichtung 10 dient hier zum Überwachen der Schließposition einer Schutztür 12, die ihrerseits zum Absichern einer automatisiert arbeitenden Anlage vorgesehen ist. Beispielhaft ist die automatisiert arbeitende Anlage hier als Roboter 14 dargestellt. Der Einsatzbereich der neuen Vorrichtung 10 ist jedoch nicht auf dieses konkrete Beispiel beschränkt. Generell kann die Vorrichtung 10 zum Überwachen jeglicher (Schließ-) Positionen zweier relativ zueinander beweglicher Teile verwendet werden. Dies beinhaltet beispielsweise auch die Überwachung einer Kolbenposition relativ zu einem Kolbenzylinder oder einem anderen Kolben, wobei der Begriff "Schließposition" in diesem Fall bedeutet, dass der Kolben sich im Bereich des anderen Gegenstandes befindet.

Die Vorrichtung 10 beinhaltet einen Betätiger 16 und einen Sensor 18. Der Betätiger 16 ist hier an der Schutztür 12 angebracht. Der Sensor 18 ist an einer Wand 20 (oder an einem hier nicht dargestellten Rahmen für die Schutztür 12) angebracht. Im geschlossenen Zustand der Schutztür 12 (hier nicht dargestellt) befindet sich der Betätiger 16 in räumlicher Nähe zum Sensor 18, was in der nachfolgend näher erläuterten Weise die Erzeugung eines Freigabesignals bewirkt. Beim Öffnen der Schutztür 12 wird der Betätiger 16 vom Sensor 18 entfernt, was zur Folge hat, dass das Freigabesignal zurückgenommen wird und eine Überwachungsmeldung, hier in Form eines Schaltsignals zum Abschalten des Roboters 14, erzeugt wird.

Der Sensor 18 ist in diesem Ausführungsbeispiel über zwei Leitungen mit einem Sicherheitsschaltgerät 22 verbunden. Eine erste Leitung 24 führt vom Sicherheitsschaltgerät 22 zum Sensor 18. Über diese Leitung kann das Sicherheitsschaltgerät 22 Testsignale in der nachfolgend näher erläuterten Weise an den Sensor 18 übertragen. Über die zweite Leitung 26 empfängt das Sicherheitsschaltgerät 22 das vom Sensor 18 erzeugte Freigabesignal.

Ausgangsseitig steuert das Sicherheitsschaltgerät 22 hier zwei Schütze 28, 30, deren Arbeitskontakte in an sich bekannter Weise in einer Stromzuführung 32 des Roboters 14 angeordnet sind. Über die Schütze 28, 30 unterbricht das Sicherheitsschaltgerät 22 die Stromzufuhr für den Roboter 14, wenn mit Hilfe der Betätiger-Sensor-Kombination 16, 18 ein Öffnen der Schutztür 12 festgestellt wird, oder wenn im Rahmen der nachfolgend beschriebenen Fehlerüberwachung ein undefinierter und damit sicherheitskritischer Zustand erkannt wird.

Bei dem Sicherheitsschaltgerät 22 handelt es sich hier gemäß einem bevorzugten Ausführungsbeispiel um ein Gerät, das die Kategorie 4 der europäischen Norm EN 954-1 oder eine vergleichbare Sicherheitsnorm erfüllt und das dementsprechend zur Absicherung von technischen Anlagen zugelassen ist. Beispielsweise handelt es sich hier um ein Sicherheitsschaltgerät des Typs PNOZ®elog der Anmelderin der vorliegenden Erfindung. Alternativ hierzu könnte der Sensor 18 jedoch auch mit einer programmierbaren Sicherheitssteuerung verbunden sein, wie diese unter der Bezeichnung PSS® ebenfalls von der Anmelderin der vorliegenden Erfindung vertrieben wird.

In dem Ausführungsbeispiel gemäß Fig. 1 ist nur eine BetätigerSensor-Kombination 16, 18 dargestellt. Es versteht sich jedoch, dass in anderen Ausführungsbeispielen auch eine Vielzahl derartiger Kombinationen eingesetzt werden kann, um die Schließposition zahlreicher Teile fehlersicher zu überwachen. In bevorzugten Ausführungsbeispielen sind dabei mehrere Betätiger-Sensor-Kombinationen 16, 18 mit einem gemeinsamen Sicherheitsschaltgerät 22 (oder einer gemeinsamen Sicherheitssteuerung) verbunden, was eine besonders effiziente und kostengünstige Absicherung einer Gesamtanlage ermöglicht.

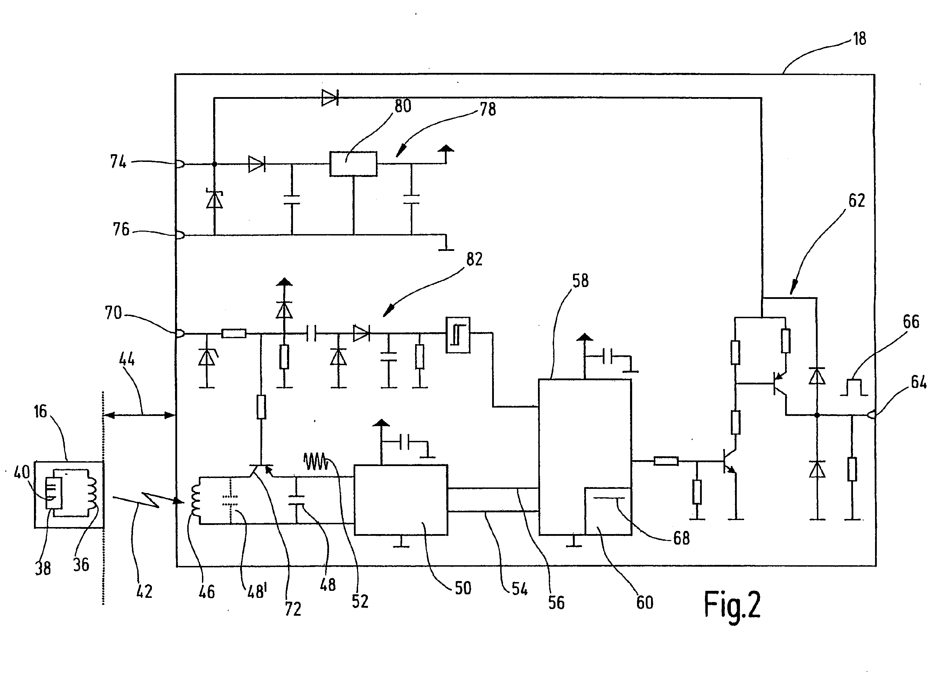

In Fig. 2 ist die Betätiger-Sensor-Kombination 16, 18 aus dem Ausführungsbeispiel gemäß Fig. 1 in weiteren Details dargestellt, wobei gleiche Bezugszeichen dieselben Elemente bezeichnen wie zuvor.

Der Betätiger 16 ist hier ein handelsüblicher passiver Transponder (in der Fachsprache manchmal auch als "Tag" bezeichnet). Er besitzt zumindest eine Spule 36 und einen Speicher 38, in dem eine Information 40, insbesondere eine Identifikationsnummer, abgespeichert ist. Die Spule 36 bildet eine Antenne, über die der Betätiger 16 elektromagnetische Signale aufnehmen und absenden kann. Wird der Betätiger 16 nahe genug an einen Sender herangebracht, der ein geeignetes Abfragesignal in Form eines elektromagnetischen Feldes abstrahlt, nimmt er über die Spule 36 Energie auf. Mit dieser Energie wird der Speicher 38 aktiviert und ein hier nicht dargestellter Modulator erzeugt ein elektromagnetisches Antwortsignal 42, dem die Information 40 aufgeprägt ist. Das Antwortsignal 42 kann mit einem geeigneten Sensor empfangen und ausgewertet werden. Insbesondere ist es damit möglich, die im Betätiger 16 abgespeicherte Information 40 berührungslos an den Sensor zu übertragen. Charakteristisch für den vorliegend bevorzugten Anwendungsfall ist dabei, dass der Transponder automatisch aktiviert wird, wenn er genügend nahe an den Sensor 18 herangeführt ist, da der Sensor 18 in nachfolgend näher beschriebener Weise das elektromagnetische Feld erzeugt, durch das der Transponder im Betätiger 16 aktiviert wird.

Ist die Entfernung zwischen Betätiger 16 und Sensor 18 hingegen zu groß, reicht die Energie des vom Sensor 18 erzeugten elektromagnetischen Feldes nicht aus, um den Transponder zu aktivieren. Infolge dessen strahlt der Transponder im Betätiger 16 dann auch kein Antwortsignal 42 ab, was hier als geöffnete Schutztür 12 interpretiert wird. Die maximale Schaltentfernung, innerhalb der der Transponder im Betätiger 16 ein auswertbares Antwortsignal 42 absendet, ist in Fig. 2 bei der Bezugsziffer 44 angedeutet.

Der Sensor 18 besitzt hier einen Empfangskreis bestehend aus einer Induktivität 46 und einer Kapazität 48. Dieser Empfangskreis ist mit einem sogenannten Tag-Reader 50 verbunden, d.h. einem Schaltkreis, der die Aktivierung und Auswertung des Transponders durchführt. Geeignete Tag-Reader sind heute als integrierte Schaltkreise (IC's) erhältlich. Der Tag-Reader 50 erzeugt mit Hilfe des Kreises 46, 48 das elektromagnetische Feld, das bei Unterschreiten der Schaltentfernung 44 den Transponder im Betätiger 16 aktiviert. Außerdem empfängt der Kreis 46, 48 das Antwortsignal 42. Er erzeugt in diesem Fall ein definiertes Empfangskreissignal, das in Fig. 2 bei der Bezugsziffer 52 angedeutet ist und ggf. die im Speicher 38 abgespeicherte Information 40 enthält. Das definierte Empfangskreissignal 52 wird im Tag-Reader 50 ausgewertet. An einem Ausgang 54 stellt der Tag-Reader 50 dann die decodierte Information 40 zur weiteren Verarbeitung bereit. Ein weiterer Ausgang ist hier mit der Bezugsziffer 56 bezeichnet und liefert ein Taktsignal, mit dessen Hilfe die decodierte Information 40 am Ausgang 54 ausgelesen werden kann.

Die beiden Ausgänge 54, 56 des Tag-Readers 50 sind einem Mikroprozessor 58 zugeführt, der die vom Tag-Reader 50 decodierte Information 40 verarbeitet. In einem integrierten Speicher 60 ist der entsprechende Programmcode für den Mikroprozessor 58 abgelegt.

Ausgangsseitig ist der Mikroprozessor 58 mit einer Verstärkerschaltung 62 verbunden. Mit deren Hilfe erzeugt der Mikroprozessor 58 an einem sensorseitigen Ausgang 64 ein Freigabesignal 66, das in dem bevorzugten Ausführungsbeispiel gemäß Fig. 1 über die Leitung 26 dem Sicherheitsschaltgerät 22 zugeführt ist. Der Mikroprozessor 58 erzeugt das Freigabesignal 66 abhängig von der vom Tag-Reader 50 decodierten Information 40, indem er diese mit einer im Speicher 60 abgespeicherten Referenzinformation 68 vergleicht. Stimmt die vom Tag-Reader 50 gelieferte Information mit der Referenzinformation 68 überein, ist davon auszugehen, dass die Schutztür 12 geschlossen ist, vorausgesetzt, dass die gesamte Vorrichtung fehlerfrei funktioniert, was in der nachfolgend näher beschriebenen Weise zyklisch überprüft wird. Stimmt die vom Tag-Reader 50 bereitgestellte Information mit der abgespeicherten Referenzinformation 68 nicht überein oder liefert der Tag-Reader 50 überhaupt keine decodierte Information, ist davon auszugehen, dass sich der Betätiger 16 außerhalb der Schaltentfernung 44 zum Sensor 18 befindet, d.h. dass die Schutztür 12 geöffnet ist. In diesem Fall nimmt der Mikroprozessor 68 das Schaltsignal 66 zurück, was dem Sicherheitsschaltgerät 22 signalisiert, dass der Roboter 14 abgeschaltet werden muss.

Der Tag-Reader 50 und der Mikroprozessor 58 bilden damit gemeinsam einen Detektorkreis im Sinne der vorliegenden Erfindung.

Mit der Bezugsziffer 70 ist ein Eingang des Sensors 18 bezeichnet, an den die Leitung 24 vom Sicherheitsschaltgerät 22 (Fig. 1) angeschlossen ist. Hierüber empfängt der Sensor 18 Testimpulse, mit deren Hilfe das Sicherheitsschaltgerät 22 die einwandfreie Funktion des Sensors 18 überprüfen kann.

Gemäß einem besonderen Aspekt der vorliegenden Erfindung erfolgt die Überprüfung hier mit Hilfe eines im Bereich des Empfangskreises 46, 48 angeordneten Schaltelements 72. Das Schaltelement 72 ist hier als pnp-Transistor ausgebildet und mit seinen Kollektor- und Emitteranschlüssen zwischen die Induktivität 46 und die Kapazität 48 geschaltet. Die Basis des Schaltelements 72 ist über ein Widerstandsnetzwerk mit dem Eingang 70 des Sensors 18 verbunden. Durch Anlegen eines geeigneten Steuersignals (hier ein High-Signal) am Eingang 70 kann mit Hilfe des Schaltelements 72 die Verbindung zwischen Induktivität 46 und Kapazität 48 aufgetrennt werden, was zur Folge hat, dass der Kreis 46, 48 kein zur Abfrage des Betätigers 16 geeignetes elektromagnetisches Feld bereitstellen kann. Infolge dessen kann der Betätiger 16 dann auch nicht mit einem Antwortsignal 42 reagieren, und zwar selbst dann nicht, wenn er sich innerhalb der Schaltentfernung 44 befindet. Ein Unterbrechen des Kreises 46, 48 hat somit zur Folge, dass der Tag-Reader 50 nicht mehr das erwartete Empfangskreissignal 52 erhält. Bei ordnungsgemäßer Funktion des Sensors 18 muss dies dazu führen, dass der Mikroprozessor 58 das Freigabesignal 66 zurücknimmt. Dementsprechend kann das Sicherheitsschaltgerät 22 durch Anlegen eines geeigneten Testsignals am Eingang 70 die Funktionsweise des Sensors 18 realistisch testen, ohne dass die Schutztür 12 tatsächlich geöffnet werden muss.

In dem bevorzugten Ausführungsbeispiel ist das Schaltelement 72 in der in Fig. 2 dargestellten Weise zwischen die Induktivität 46 und die Kapazität 48 geschaltet. Alternativ hierzu ist es jedoch auch möglich, das Schaltelement 72 zwischen den Empfangskreis 46, 48 und den Tag-Reader 50 zu schalten, was ebenfalls zur Folge hat, dass aus Sicht des Tag-Readers 50 das definierte Empfangskreissignal 52 unterdrückt wird, wenn ein geeignetes Schaltsignal am Eingang 70 anliegt. Darüber hinaus ist die Verwendung des hier gezeigten pnp-Transistors nur eine bevorzugte Möglichkeit, das Schaltelement 72 kann gleichermaßen auch auf andere Weise realisiert sein.

Der Sensor 18 besitzt im hiesigen Ausführungsbeispiel zwei weitere Eingänge 74, 76, an die eine Versorgungsspannung von je 24 Volt angelegt werden kann. Ein mit den Eingängen 74, 76 verbundenes Netzteil 78 erzeugt hieraus mit Hilfe eines Spannungsreglers 80 eine 5 Volt-Betriebsspannung, mit der insbesondere der Tag-Reader 50 und der Mikroprozessor 58 versorgt werden.

Mit der Bezugsziffer 82 ist ferner eine Filterschaltung bezeichnet, über die das am Eingang 70 des Sensors 18 anliegende Signal auch dem Mikroprozessor 58 zugeführt ist. Mit dieser Filterschaltung 82 ist es möglich, den Mikroprozessor 58 über ein geeignetes Signal am Eingang 70, in der derzeit bevorzugten Realisierung beispielsweise ein Signal mit einer bestimmten Frequenz, in einen Lernmodus zu versetzen. Die Filterschaltung 82 erzeugt aus dem Signal am Eingang 70 ein Statussignal, das dem Mikroprozessor 58 signalisiert, dass er die vom Tag-Reader 50 decodierte Information im Speicher 60 als Referenzinformation 68 ablegen soll. Auf diese Weise ist es möglich, den Sensor 18 auf einen individuellen Betätiger 16 einzulernen, so dass nachfolgend nur noch dieser Betätiger 16 (oder ein anderer Betätiger, in dem dieselbe Information 40 abgespeichert ist) eine geschlossene Schutztür 12 signalisieren kann. Abweichend von dieser Ausführung ist es jedoch grundsätzlich auch möglich, die Referenzinformation 68 auf andere Weise, beispielsweise bei der Programmierung des Mikroprozessors 58 im Speicher 60 abzulegen.

Nach dem Lernvorgang nimmt das Sicherheitsschaltgerät 22 das Signal am Eingang 70 zurück und geht in den normalen Überwachungsmodus über. In diesem Überwachungsmodus steuert das Sicherheitsschaltgerät 22 das Schaltelement 72 zyklisch an, um den Empfangskreis 46, 48 zu unterbrechen. Wenn der Mikroprozessor 58 daraufhin das Freigabesignal 66 zurücknimmt, kann von einer ordnungsgemäßen Funktion des Sensors 18 ausgegangen werden. Sollte der Mikroprozessor 58 auf die Unterbrechung des Empfangskreises 46, 48 allerdings nicht reagieren, liegt ein undefinierter und damit kritischer Zustand vor, was dazu führt, dass das Sicherheitsschaltgerät 22 den Roboter 14 abschaltet.

Dadurch, dass das Sicherheitsschaltgerät 22 den Sensor 18 von außen einfach überprüfen kann, ist es möglich, innerhalb des Sensors 18 einen einkanaligen Aufbau zu realisieren, der zudem mit vergleichsweise einfachen und damit kostengünstigen Komponenten erfolgen kann. Des weiteren ist es damit möglich, die Verbindung zwischen Sensor 18 und Sicherheitsschaltgerät 22 einkanalig zu realisieren. Infolgedessen lässt sich der Sensor 18 im hier dargestellten Ausführungsbeispiel mit einem relativ kleinen M8-Stecker realisieren, wohingegen gattungsgemäße Vorrichtungen in aller Regel einen größeren und auch teureren M12-Stecker benötigen.

Die Aktivierung des Lernmodus erfolgt im hiesigen Ausführungsbeispiel bevorzugt dadurch, dass am Sicherheitsschaltgerät 22 eine besondere Drahtbrücke gelegt wird, die das Sicherheitsschaltgerät 22 veranlasst, das erforderliche Signal an der Leitung 24 anzulegen. Alternativ könnten hierbei jedoch auch andere Lösungen, beispielsweise die Verwendung eines Schlüsselschalters zum Einsatz kommen.

## Patentansprüche

1. Vorrichtung zum sicheren Überwachen einer Schließposition zweier relativ zueinander beweglicher Teile (12, 20), insbesondere zur Verwendung als Türkontaktschalter bei einer Schutztür zum Absichern einer automatisiert arbeitenden technischen Anlage (14), mit einem Betätiger (16) und mit einem Sensor (18), die an jeweils einem der Teile (12, 20) fixierbar sind, wobei der Sensor (18) einen eingangsseitigen Empfangskreis (46, 48) aufweist, der bei Unterschreiten einer Schaltentfernung (44) zwischen Sensor (18) und Betätiger (16) ein definiertes Empfangskreissignal (52) erzeugt, mit einem Detektorkreis (50, 58), der bei Vorliegen des definierten Empfangskreissignals (52) ein Freigabesignal (66) bereitstellt, und mit einem Testelement, **dadurch gekennzeichnet, dass** das Testelement dazu ausgebildet ist, das definierte Empfangskreissignal (52) gezielt zu unterdrücken, wobei der Empfangskreis (46, 48) eine Induktivität (46) und eine damit verbundenen Kapazität (48) beinhaltet und das Testelement (72) dazu ausgebildet ist, die Induktivität (46) und die Kapazität (48) elektrisch voneinander zu trennen, oder wobei das Testelement (72) dazu ausgebildet ist, den Empfangskreis (46, 48) von dem Detektorkreis (50, 58) zu trennen.

2. Vorrichtung nach Anspruch 1, **dadurch gekennzeichnet, dass** das Testelement (72) im Bereich des Empfangskreises (46, 48) angeordnet ist.

3. Vorrichtung nach einem der Ansprüche 1 oder 2, **dadurch gekennzeichnet, dass** der Betätiger (16) ein Transponderelement mit einer darin abgelegten Information (40) beinhaltet, vorzugsweise ein Transponder ist, und dass der Sensor (18) dazu ausgebildet ist, die Information (40) bei Unterschreiten der Schaltentfernung (44) mit Hilfe des Empfangskreises (46, 48) auszulesen.

4. Vorrichtung nach Anspruch 3, **dadurch gekennzeichnet, dass** der Sensor (18) dazu ausgebildet ist, die Information (40) bei Unterschreiten der Schaltentfernung (44) stetig wiederholt auszulesen.

5. Vorrichtung nach Anspruch 3 oder 4, **dadurch gekennzeichnet, dass** der Detektorkreis (50, 58) einen Logikbaustein (58) beinhaltet, der das Freigabesignal (66) nur dann bereitstellt, wenn die Information (40) aus dem Betätiger (16) mit einer vorgegebenen Information (68) übereinstimmt.

6. Vorrichtung nach einem der Ansprüche 3 bis 5, **dadurch gekennzeichnet, dass** der Detektorkreis (50, 58) einen Betriebsmodus aufweist, in dem der Logikbaustein (58) die vorgegebene Information (68) einliest, und zwar vorzugsweise vom Betätiger (16).

7. Vorrichtung nach einem der Ansprüche 1 bis 6, **gekennzeichnet durch** eine vorzugsweise räumlich vom Sensor (18) abgesetzte Auswerte- und Steuereinheit (22), die dazu ausgebildet ist, das erste Empfangskreissignal (52) mit Hilfe des Testelements (72) zyklisch zu unterdrücken.

8. Vorrichtung nach einem der Ansprüche 1 bis 7, **dadurch gekennzeichnet, dass** der Detektorkreis (50, 58) im Sensor (18) integriert ist.

9. Vorrichtung nach einem der Ansprüche 1 bis 8, **dadurch gekennzeichnet, dass** der Detektorkreis (50, 58) einkanalig ausgebildet ist.

10. Sensor zur Verwendung in einer Vorrichtung nach einem der Ansprüche 1 bis 9, mit einem eingangsseitigen Empfangskreis (46, 48), der bei Unterschreiten einer Schaltentfernung (44) zu einem räumlich abgesetzten Betätiger (16) ein definiertes Empfangskreissignal (52) erzeugt, mit einem Detektorkreis (50, 58), der bei Vorliegen des definierten Empfangskreissignals (52) ein Freigabesignal (66) bereitstellt, und mit einem Testelement, **dadurch gekennzeichnet, dass** das Testelement dazu ausgebildet ist, das definierte Empfangskreissignal (52) gezielt zu unterdrücken, wobei der Empfangskreis (46, 48) eine Induktivität (46) und eine damit verbundenen Kapazität (48) beinhaltet und das Testelement (72) dazu ausgebildet ist, die Induktivität (46) und die Kapazität (48) elektrisch voneinander zu trennen, oder wobei das Testelement (72) dazu ausgebildet ist, den Empfangskreis (46, 48) von dem Detektorkreis (50, 58) zu trennen.

11. Verfahren zum sicheren Überwachen einer Schließposition zweier relativ zueinander beweglicher Teile (12, 20), insbesondere zum Absichern einer automatisiert arbeitenden technischen Anlage (14) mit Hilfe einer Schutztür, mit den Schritten:
- Anordnen eines Betätigers (16) an einem der beweglichen Teile (12),
- Anordnen eines Sensors (18) mit einem eingangsseitigen Empfangskreis (46, 48) an dem anderen der beweglichen Teile (20),
- Erzeugen eines definierten Empfangskreissignals (52) mit Hilfe des Empfangskreises (46, 48), wenn eine Schaltentfernung (44) zwischen Sensor (18) und Betätiger (16) unterschritten wird,
- Erzeugen eines Freigabesignals (66) mit Hilfe eines Detektorkreises (50, 58), wenn das definierte Empfangskreissignal (52) vorliegt, und
- Testen des Sensors (18) mit Hilfe eines Testelements,
**dadurch gekennzeichnet, dass** bei Vorliegen des definierten Empfangskreissignals (52) dieses mit Hilfe des Testelements kurzeitig unterdrückt wird, wobei der Empfangskreis (46, 48) eine Induktivität (46) und eine damit verbundenen Kapazität (48) beinhaltet und das Testelement (72) dazu ausgebildet ist, die Induktivität (46) und die Kapazität (48) elektrisch voneinander zu trennen, oder wobei das Testelement (72) dazu ausgebildet ist, den Empfangskreis (46, 48) vom Detektorkreis (50, 58) zu trennen, und dass eine Überwachungsmeldung erzeugt wird, wenn der Detektorkreis (50, 58) auf die Unterdrückung des definierten Empfangskreissignals (52) nicht reagiert.

## Claims

1. A device for reliably monitoring a closed position of two parts (12, 20) which can move relative to one another, in particular for use as a door contact switch in a protective door for safeguarding a technical installation (14) which operates in an automated fashion, the device comprising an actuator (16) and a sensor (18), which actuator (16) and sensor (18) can each be secured to one of the parts (12, 20), the sensor (18) having a receiver circuit (46, 48) at an input side, which receiver circuit generates a defined receiver circuit signal (52) when a switching distance (44) between the sensor (18) and the actuator (16) is fallen short of, comprising a detector circuit (50, 58) for providing an enable signal (66) when the defined receiver circuit signal (52) is present, and with a test element, **characterized in that** the test element is designed to selectively suppress the defined receiver circuit signal (52), wherein the receiver circuit (46, 48) comprises an inductor (46) and a capacitor (48) connected thereto and the test element (72) is designed to isolate the inductor (46) and the capacitor (48) from one another electrically, or wherein the test element (72) is designed to isolate the receiver circuit (46, 48) from the detector circuit (50, 58).

2. The device of claim 1, **characterized in that** the test element (72) is arranged in the region of the receiver circuit (46, 48).

3. The device of anyone of claims 1 or 2, **characterized in that** the actuator (16) comprises a transponder element with information (40) stored therein, and it is preferably a transponder, and **in that** the sensor (18) is designed to read out the information (40) using the receiver circuit (46, 48) when the switching distance (44) is fallen short of.

4. The device of claim 3, **characterized in that** the sensor (18) is designed to read out the information (40) in a continuously repeated fashion when the switching distance (44) is fallen short of.

5. The device of claim 3 or 4, **characterized in that** the detector circuit (50, 58) comprises a logic module (58) which provides the enable signal (66) only if the information (40) from the actuator (16) corresponds to predefined information (68).

6. The device of anyone of claims 3 to 5, **characterized in that** the detector circuit (50, 58) has an operating mode in which the logic module (58) reads in the predefined information (68), preferably from the actuator (16).

7. The device of anyone of claims 1 to 6, **characterized by** an evaluation and control unit (22) which is designed to suppress the first receiver circuit signal (52) cyclically using the test element (72), and which is preferably spatially remote from the sensor (18)

8. The device of anyone of claims 1 to 7, **characterized in that** the detector circuit (50, 58) is integrated in the sensor (18).

9. The device of anyone of claims 1 to 8, **characterized in that** the detector circuit (50, 58) is of single-channel design.

10. A sensor for use in a device of anyone of claims 1 to 9, comprising a receiver circuit (46, 48) at an input side, which receiver circuit generates a defined receiver circuit signal (52) when a switching distance (44) from a spatially remote actuator (16) is fallen short of, comprising a detector circuit (50, 58) for providing an enable signal (66) when the defined receiver circuit signal (52) is present, and with a test element, **characterized in that** the test element is designed to selectively suppress the defined receiver circuit signal (52), wherein the receiver circuit (46, 48) comprises an inductor (46) and a capacitor (48) connected thereto and the test element (72) is designed to isolate the inductor (46) and the capacitor (48) from one another electrically, or wherein the test element (72) is designed to isolate the receiver circuit (46, 48) from the detector circuit (50, 58).

11. A method for reliably monitoring a closed position of two parts (12, 20) which can move relative to one another, in particular for safeguarding a technical installation (14), which operates in an automated fashion, using a protective door, the method comprising the steps of:
- arranging an actuator (16) on one of the moving parts (12),
- arranging a sensor (18) having a receiver circuit (46, 48) at an input side on the other of the moving parts (20),
- generating a defined receiver circuit signal (52) using the receiver circuit (46, 48) if a switching distance (44) between the sensor (18) and actuator (16) is fallen short of, and
- generating an enable signal (66) using a detector circuit (50, 58) if the defined receiver circuit signal (52) is present, and
- testing the sensor (18) with the help of the test element,
**characterized in that** when the defined receiver circuit signal (52) is present it is briefly suppressed using the test element, wherein the receiver circuit (46, 48) comprises an inductor (46) and a capacitor (48) connected thereto and the test element (72) is designed to isolate the inductor (46) and the capacitor (48) from one another electrically, or wherein the test element (72) is designed to isolate the receiver circuit (46, 48) from the detector circuit (50, 58), and **in that** a monitoring message is generated if the detector circuit (50, 58) does not react to the suppression of the defined receiver circuit signal (52).

## Revendications

1. Dispositif de surveillance sûre de la position de fermeture de deux parties (12, 20) mobiles l'une par rapport à l'autre,
le dispositif étant en particulier destiné à être utilisé comme contact de commutation d'une porte de protection qui protège une installation technique (14) travaillant de manière automatique,
le dispositif présentant
un actionneur (16) et un détecteur (18) qui peuvent être fixés respectivement sur l'une des parties (12, 20),
le détecteur (18) présentant un circuit de réception (46, 48) disposé du côté de son entrée et formant un signal défini (52) du circuit de réception lorsqu'une distance de commutation (44) entre le détecteur (18) et l'actionneur (16) n'est pas atteinte,
un circuit de détection (50, 58) qui délivre un signal de libération (66) lorsque le signal défini (52) du circuit de réception est présent et
un élément de test,
**caractérisé en ce que**
l'élément de test est configuré de manière à supprimer de manière contrôlée le signal défini (52) du circuit de réception,
**en ce que** le circuit de réception (46, 48) contient une inductance (46) à laquelle est reliée une capacité (48) et
**en ce que** l'élément de test (72) est configuré pour séparer électriquement l'une de l'autre l'inductance (46) et la capacité (48) ou
**en ce que** l'élément de test (72) est configuré pour séparer le circuit de réception (46, 48) du circuit de détection (50, 58).

2. Dispositif selon la revendication 1, **caractérisé en ce que** l'élément de test (72) est disposé au niveau du circuit de réception (46, 48).

3. Dispositif selon l'une des revendications 1 ou 2, **caractérisé en ce que** l'actionneur (16) contient un élément transpondeur dans lequel une information (40) est placée et est de préférence un transpondeur et **en ce que** le détecteur (18) est configuré pour lire l'information (40) à l'aide du circuit de réception (46, 48) lorsque la distance de commutation (44) n'est plus atteinte.

4. Dispositif selon la revendication 3, **caractérisé en ce que** le détecteur (18) est configuré pour lire en permanence et de manière répétée l'information (40) lorsque la distance de commutation (44) n'est plus atteinte.

5. Dispositif selon les revendications 3 ou 4, **caractérisé en ce que** le circuit de détection (50, 58) contient un module logique (58) qui ne délivre le signal de libération (66) que si l'information (40) provenant de l'actionneur (16) correspond à une information (68) prédéterminée.

6. Dispositif selon l'une des revendications 3 à 5, **caractérisé en ce que** le circuit de détection (50, 58) présente un mode de fonctionnement dans lequel le module logique (58) lit l'information prédéterminée (68) et ce de préférence depuis l'actionneur (16).

7. Dispositif selon l'une des revendications 1 à 6, **caractérisé par** une unité d'évaluation de commande (22), de préférence séparée spatialement du détecteur (18) et configurée de manière à supprimer cycliquement le premier signal (52) du circuit de réception à l'aide de l'élément de test (72).

8. Dispositif selon l'une des revendications 1 à 7, **caractérisé en ce que** le circuit de détection (50, 58) est intégré dans le détecteur (18).

9. Dispositif selon l'une des revendications 1 à 8, **caractérisé en ce que** le circuit de détection (50, 58) est configuré à un seul canal.

10. Détecteur destiné à être utilisé dans un dispositif selon l'une des revendications 1 à 9 et présentant
un circuit de réception (46, 48) disposé du côté de son entrée et formant un signal défini (52) du circuit de réception lorsqu'une distance de commutation (44) par rapport à un actionneur (16) éloigné spatialement n'est pas atteinte,
un circuit de détection (50, 58) qui délivre un signal de libération (66) lorsque le signal défini (52) du circuit de réception est présent et
un élément de test,
**caractérisé en ce que**
l'élément de test est configuré de manière à supprimer de manière contrôlée le signal défini (52) du circuit de réception,
**en ce que** le circuit de réception (46, 48) contient une inductance (46) à laquelle est reliée une capacité (48) et
**en ce que** l'élément de test (72) est configuré pour séparer électriquement l'une de l'autre l'inductance (46) et la capacité (48) ou
**en ce que** l'élément de test (72) est configuré pour séparer le circuit de réception (46, 48) du circuit de détection (50, 58).

11. Procédé de surveillance sûre de la position de fermeture de deux parties (12, 20) aptes à se déplacer l'une par rapport à l'autre, et en particulier pour assurer à l'aide d'une porte de protection la sécurité d'une installation technique (14) travaillant de manière automatique, le procédé présentant les étapes qui consistent à :
placer un actionneur (16) sur l'une des parties mobiles (12),
placer un détecteur (18) doté du côté de son entrée d'un circuit de réception (46, 48) sur l'autre des parties mobiles (20),
former un signal défini (52) du circuit de réception à l'aide du circuit de réception (46, 48) lorsqu'une distance de commutation (44) n'est plus atteinte entre le détecteur (18) et l'actionneur (16),
former un signal de libération (66) à l'aide d'un circuit de détection (50, 58) lorsque le signal défini (52) du circuit de réception est présent et
tester le détecteur (18) à l'aide d'un élément de test,
**caractérisé en ce que**
lorsque le signal défini (52) du circuit de réception est présent, supprimer brièvement ce signal à l'aide de l'élément de test, le circuit de réception (46, 48) contenant une inductance (46) à laquelle est reliée une capacité (48),
**en ce que** l'élément de test (72) est configuré pour séparer électriquement l'une de l'autre l'inductance (46) et la capacité (48) ou
**en ce que** l'élément de test (72) est configuré pour séparer le circuit de réception (46, 48) du circuit de détection (50, 58) et
**en ce qu'**un message de surveillance est formé lorsque le circuit de détection (50, 58) ne réagit pas à la suppression du signal défini (52) du circuit de réception.
